# EUROPÄISCHE PATENTSCHRIFT

(11) **EP 0 404 025 B1**
(45) Veröffentlichungstag und Bekanntmachung des Hinweises auf die Patenterteilung: **05.04.1995**
(21) Anmeldenummer: 90111479.3
(22) Anmeldetag: 18.06.1990
(51) Int. Cl.: G09G 3/36, H03K 17/04, H04N 3/12

(54) **Schaltungsanordnung zur Ansteuerung von Schaltelementen, die insbesondere geeignet ist für Flüssigkristallbildschirme**
Driver circuit for switching elements, especially for liquid crystal screens
Circuit de commande d'éléments de montage, en particulier pour écrans à cristaux liquides

(30) Priorität: 19.06.1989 DE 3919964
(43) Veröffentlichungstag der Anmeldung: 27.12.1990
(73) Patentinhaber: Heimann Optoelectronics GmbH, D-65199 Wiesbaden (DE)
(72) Erfinder: Khakzar, Karim, Dipl.-Ing., D-7000 Stuttgart 50 (DE)
(74) Vertreter: Beetz & Partner Patentanwälte

(56) Entgegenhaltungen:
- EP-A- 0 057 025
- EP-A- 0 269 744
- EP-A- 0 297 623
- GB-A- 2 194 663
- US-A- 4 829 201

## Beschreibung

Die Erfindung betrifft eine Schaltungsanordnung zur Ansteuerung eines Schaltelementes.

Bildschirme mit Kathodenstrahlröhren werden in Zukunft im Fernseh- und Computerbereich vermehrt durch aktive Flüssigkristallbildschirme (sog. LCD) ersetzt. Diese Flüssigkristallbildschirme weisen eine Vielzahl von Vorteilen auf: geringes Gewicht, flache Bauweise, geringe Verzerrung des darzustellenden Bildes, niedrige Ansteuerspannungen, die Möglichkeit der Projektion auf eine große Leinwand, hohe Auflösung, das Fehlen von schädlichen Röntgenstrahlen, die Herstellbarkeit in einer preiswerten Technologie, die sich auch für großflächige Anwendungen eignet.

Flüssigkristallbildschirme bestehen aus einer matrixförmigen Anordnung von Bildpunkten, wobei jedem Bildpunkt ein Schaltelement zugeordnet ist. Als Schaltelemente werden vielfach Dünnfilmtransistoren verwendet. Die Bildinformation wird an die Spalten angelegt und zeilenweise über die Schaltelemente in die Bildpunktspeicher geschrieben. Daher müssen die Zeilen so angesteuert werden, daß jeweils nur eine Zeilenleitung der insgesamt N Zeilen für 1/N-tel der Bildaufbauzeit ein genügend hohes Potential besitzt, so daß die Bildpunktkapazität über das Schaltelement bis auf die der Bildinformation entsprechende Datenspannung aufgeladen werden kann. Es muß sichergestellt sein, daß sich die Bildpunktkapazität während der übrigen Bildwiederholzeit nicht über das Schaltelement entladen kann.

In vielen Anwendungen, wie zum Beispiel bei Bildschirmen mit hoher Bildpunktzahl und/oder kleiner Bildpunktgröße ist es vorteilhaft, die Schaltungsanordnung zur Ansteuerung der Zeilenleitungen auf dem Bildschirm-Substrat zu integrieren. Das erfordert, daß die Schaltungsanordnung in derselben Technologie wie der Bildschirm herstellbar ist.

Aus der Literatur sind verschiedene Lösungen zur Integration der Zeilenansteuerschaltung in einem dem Bildschirmprozeß kompatiblen Herstellungsprozeß direkt auf dem Glassubstrat bekannt (Y. Oana et al: 1984 SID Symposium Digest p. 312-315, S. Morozumi et al: 1984 SID Symposium Digest p. 316-319, J. Ohwada et al: Conf. Record of the 1988 inter. Res. Conf. p. 215-219, B.W.Faughnan et al: Proc. of the SID Vol. 29/4 1988 p. 279-282, I.De Rycke et al: Conf. Record of the 1988 inter. Res. Conf. p. 70-73, M.Akiyama et al: Japan Display 1986 p. 212-215). Diese Zeilentreiberschaltungen bestehen aus einem N-stufigen Schieberegister und N Ausgangstreiberstufen. Die Ausgangsstufen müssen in der Lage sein, die zu treibende kapazitive Last, die die Eingangskapazitäten der Schaltelemente sowie die Überkreuzungskapazitäten der Zeilen-und Spaltenleitungen enthält, in der kurzen Zeilenansteuerzeit zu laden und zu entladen.

Aus der Literatur ist sowohl die Verwendung statischer (s. Y. Oana et al: 1984 SID Symposium Digest p. 312-315, S. Morozumi et al: 1984 SID Symposium Digest p. 316-319, B.W. Faughnan et al: Proc. of the SID Vol. 29/4 1988 p. 279-282, M.Akiyama et al: Japan Display 1986 p. 212-215) als auch dynamischer (s. S. Morozumi et al: 1984 SID Symposium Digest p. 316-319, J.Ohwada et al: Conf. Record of the 1988 inter. Res. Conf. p. 215-219, I.De Rycke et al: Conf. Record of the 1988 inter. Res. Conf. p. 70-73) Schieberegister bekannt. Eine Stufe eines statischen Schieberegisters besteht im allgemeinen aus zwei bistabilen Kippstufen, die durch mindestens 12 Transistoren, hier zum Beispiel in Dünnfilmtechnik, realisiert werden. Dynamische Schieberegisterstufen setzen sich aus zwei hintereinandergeschalteten Invertern zusammen und benötigen lediglich vier bis sechs Transistoren. Für die Ausgangstreiberstufen sind ebenfalls mehrere Lösungen bekannt. Eine einfache Lösung aus Y. Oana et al: 1984 SID Symposium Digest p. 312-315 besteht lediglich aus zwei in Serie geschalteten Invertern. Als Ausgangstreiberstufe werden auch sog. Push-Pull-Stufen verwendet, die aus zwei breitkanaligen Dünnfilmtransistoren bestehen. Dem Schieberegister und der Push-Pull-Stufe werden mehrere Inverterstufen (s. J. Ohwada et al: Conf. Record of the 1988 inter. Res. Conf. p. 215-219, B.W.Faughnan et al: Proc. of the SID Vol. 29/4 1988 p. 279-282, M.Akiyama et al: Japan Display 1986 p. 212-215) oder Verstärkerschaltungen (s. J.Ohwada et al: Conf. Record of the 1988 inter. Res. Conf. p. 215-219, I.De Rycke et al: Conf. Record of the 1988 inter. Res. conf. p. 70-73) zwischengeschaltet. Nur jeweils ein Transistor der Push-Pull-Stufe ist leitend und verbindet den Ausgang entweder mit einem hohen oder einem niedrigen Potential.

Die Gesamtzahl der benötigten Transistoren pro Zeilenansteuerstufe erhöht sich durch die bekannten Ausgangsstufen um vier bis zwölf. Berücksichtigt man zwei Taktsignale φ1 und φ2 für die Ansteuerung des Schieberegisters und mindestens eine weitere Batteriespannung für die Push-Pull-Stufe bzw. die Ausgangsinverterstufe, so ergeben sich viele Leitungsüberkreuzungen pro Zeilenansteuerstufe. In der Dünnfilmtechnik kann jeder Defekt an einer Überkreuzung oder einem Dünnfilmtransistor zu Funktionsstörungen oder dem Ausfall der Schaltung führen. Da Bildschirme mit großer Auflösung eine große Anzahl von Zeilen aufweisen können (ca. 500 - 1000), muß angestrebt werden, die einzelnen Zeilenansteuerstufen so einfach wie möglich vorzusehen. Die aus der Literatur bekannten und realisierten Schaltungen weisen mindestens 14 Transistoren auf. Dieser Aufwand erscheint nicht vertretbar, da die Herstellungsausbeute durch die Vielzahl von Transistoren und Überkreuzungen stark abnimmt.

Das gleiche Problem tritt bei einer kettenförmigen Anordnung von Schaltelementen, zum Beispiel den Schaltelementen zum Auslesen der Signale einer Bildsensorzeile oder Ansteuerung von Schalttransistoren einer Druckerkopfzeile, auf.

Der Erfindung liegt die Aufgabe zugrunde, eine Schaltungsanordnung zur Ansteuerung eines Schaltelementes anzugeben, die in der Lage, ist die Lastkapazität schnell genug zu laden und entladen, die mit einer sehr geringen Anzahl von Transistoren und Leitungsüberkreuzungen auskommt und die in einem dem Flüssigkristallbildschirmprozeß kompatiblen Herstellungsprozeß herstellbar ist.

Die Aufgabe wird erfindungsgemäß gelöst durch eine Schaltungsanordnung zur Ansteuerung eines Schaltelementes mit folgenden Merkmalen:
a) es ist eine Schieberegisterstufe vorgesehen, die einen Eingangsimpuls mit Hilfe von zwei Taktsignalen zeitverzögert an den Ausgang der Schieberegisterstufe überträgt,
b) es ist eine Treiberschaltung vorgesehen, die mindestens einen Treibertransistor und einen Speicherkondensator enthält, der während des Anliegens des Eingangsimpulses an der Schieberegisterstufe vorgeladen wird und dafür sorgt, daß der Treibertransistor durch eine hohe Steuerspannung große Lade- und Entladeströme liefert.

Wird ein Eingangsimpuls zeitverzögert auf den Ausgang des Schieberegisters übertragen, addiert sich die Spannung des vorgeladenen Speicherkondensators zum Ausgangssignal des Schieberegisters, so daß die Steuerspannung des Treibertransistors hohe Werte annimmt. Über den nun sehr niederohmigen Treibertransistor kann der Ausgang mit einem hohen Potential verbunden werden.

Das Vorladen des Speicherkondensators erfolgt erfindungsgemäß über einen Ladetransistor, der mit dem Eingang der Schieberregisterstufe verbunden ist. Der Steueranschluß des Ladetransistors ist mit dem ersten Taktsignal verbunden. Der Ausgang der Schieberegisterstufe ist über einen Speicherkondensator mit dem Steueranschluß des Treibertransistors verbunden. Liefert das erste Taktsignal einen Impuls, wird der Ladetransistor leitend und verbindet den Speicherkondensator niederohmig mit dem Eingang des Schieberegisters. Liegt nun gleichzeitig am Eingang des Schieberegisters ein Impuls an, wird der Speicherkondensator aufgeladen. Eine halbe Taktperiode später, nachdem das erste Taktsignal wieder ein niedriges Potential angenommen hat, wird mit dem Impuls des zweiten Taktsignals auch auf den Ausgang des Schieberegisters ein Impuls übertragen. Da der Ladetransistor sperrt, bleibt die Spannung des Speicherkondensators erhalten und addiert sich zum Ausgangsimpuls des Schieberegisters. Die sich ergebende hohe Steuerspannung garantiert ein schnelles Laden und Entladen einer Lastkapazität durch den Treibertransistor.

Zur Übertragung eines hohen Potentials über den Treibertransistor an den Ausgang der Treiberschaltung, eignet sich zum Beispiel das zweite Taktsignal, welches während dieser Zeit ein hohes Potential besitzt.

Das Taktsignal liegt von außen am Treibertransistor an und kann daher in der Amplitude so eingestellt werden, daß das Potential zum Schalten des Schaltelementes ausreicht. Nach dem Abklingen des Taktimpulses entlädt sich der Ausgang über den Treibertransistor, der nach wie vor leitend ist, da im Speicherkondensator weiterhin eine hohe Spannung gespeichert ist.

Es liegt im Rahmen der Erfindung, einen Entladetransistor vorzusehen, der den Ausgang der Treiberschaltung mit dem Massepotential verbindet. Der Entladetransistor wird so gesteuert, daß er sperrt, wenn der Treibertransistor leitet. Während der Zeit zwischen zwei Impulsen am Treiberausgang sorgt der Entladetransistor dafür, daß sich eventuelle Spannungsstörungen an der Ladekapazität sehr schnell entladen.

Als Steuerspannung für den Entladetransistor eignet sich zum Beispiel das erste Taktsignal. Der zeitliche Verlauf der periodischen Taktsignale ist so gewählt, daß jeweils höchstens ein Taktsignal eine hohe Spannung besitzt. Zwischen den Taktimpulsen führen beide Taktsignale für eine bestimmte Zeit ein niedriges Potential, so daß die Überlappung von Taktimpulsen ausgeschlossen ist.

Es liegt ferner im Rahmen der Erfindung, die Schieberegisterstufe aus zwei getakteten Inverterstufen und einem Ladekondensator aufzubauen. Dabei ist die Versorgungsleitung jeder Inverterstufe jeweils mit einem der Taktsignale verbunden. Der Eingang der ersten Inverterstufe bildet den Eingang der Schieberegisterstufe. Der Ausgang der ersten Inverterstufe ist mit dem Eingang der zweiten Inverterstufe und über den Ladekondensator mit dem Massepotential verbunden. Der Ausgang der zweiten Inverterstufe bildet den Ausgang des Schieberegisters. Jede Inverterstufe kann aus zwei Transistoren aufgebaut werden. Daher hat dieser Vorschlag den Vorteil, daß die sich ergebende Ansteuerschaltung nur sieben Transistoren aufweist.

Ein weiterer Vorteil besteht darin, daß der Steueranschluß des Entladetransistors mit dem Ausgang der ersten Inverterstufe verbunden werden kann. Da der Ausgang der ersten Inverterstufe nur bei Anliegen eines Eingangssignals und während des unmittelbar darauf folgenden Halbtaktes auf tiefem Potential ist, bedeutet das, daß der Entladetransistor nur während des Anliegens eines Eingangssignales und in dem darauf folgenden Takt sperrt. Während der übrigen Zeit wird der Ausgang über den Entladetransistor niederohmig mit dem Massepotential verbunden.

Es liegt im Rahmen der Erfindung, als Schieberegisterstufe ein statisches Schieberegister, zum Beispiel zwei in Reihe geschaltete bistabile Kippstufen, zu verwenden.

Die erfindungsgemäße Schaltungsanordnung kann ohne weiteres erweitert werden auf eine Schaltungsanordnung, die geeignet ist, eine Kette oder eine Matrix von Schaltelementen anzusteuern. Bei einer Matrix aus Spalten und Zeilen sind jeweils alle Steueranschlüsse der Schaltelemente einer Zeile miteinander verbunden und werden somit von einem Ausgang der Schaltungsanordnung angesteuert.

Die einzelnen Schaltungsstufen sind genau aufgebaut wie die oben erläuterten erfindungsgemäßen Schaltungsanordnungen zur Ansteuerung eines einzelnen Schaltelementes. Es wird jeweils der Ausgang einer Schieberegisterstufe einer Zeile mit dem Eingang der nächsten Schieberegisterstufe verbunden. Das Taktsignal, das bei einer Schieberegisterstufe an der ersten Inverterstufe anliegt, liegt in der nächsten Schieberegisterstufe an der zweiten Inverterstufe an. Entsprechend liegt das Taktsignal, das in einer Schieberegisterstufe an der zweiten Inverterstufe anliegt, in der nächsten Schieberegisterstufe an der ersten Inverterstufe an. Der Ladetransistor wird immer mit dem Taktsignal der ersten Inverterstufe gesteuert. Diese Verschaltung stellt sicher, daß ein am Eingang der ersten Stufe anliegendes Signal bei der kettenförmigen Anordnung der Schaltelemente zum Schalten des ersten Elements führt und bei der matrixförmigen Anordnung zum Schalten der Elemente der ersten Zeile. Das gegenüber dem Eingangssignal der ersten Schieberegisterstufe um eine halbe Taktperiode verschobene Ausgangssignal der ersten Schieberegisterstufe wird am Eingang der zweiten Stufe den gleichen jedoch zeitverzögerten Vorgang in der zweiten Stufe auslösen.

Auf diese Weise wird das Eingangssignal sukzessive durch sämtliche Schieberegisterstufen der einzelnen Zeilen geschoben. Während des zeilenweisen Ansteuerns der Schaltelemente werden zum Beispiel in einem Flüssigkristallbildschirm die Bildinformationen über die Spaltenleitungen in die Bildspeicher geschrieben. Nachdem das Eingangssignal sämtliche Zeilen durchlaufen hat, ist das Bild vollständig aufgebaut. Die Pulsfolge des extern anliegenden Eingangsimpulses muß so vorgesehen sein, daß nach dem Durchlaufen aller Zeilen an der ersten Zeile wieder ein Eingangssignal anliegt.

Beim Ansteuern von Schaltelementen, die in einer Kette oder matrixförmig angeordnet sind, muß die Treiberstufe in der Lage sein, die effektive Lastkapazität, bestehend aus der Eingangskapazität des Schaltelements und eventuell vorhandenen parasitären Kapazitäten, in möglichst kurzer Zeit auf eine vorgegebene Steuerspannung aufzuladen und anschließend möglichst schnell wieder zu entladen. In der erfindungsgemäßen Schaltung führen die hohen Steuerspannungen am Treibertransistor zu großen Lade- und Entladeströmen der Lastkapazität und zu einem Aufladen dieser Lastkapazität bis auf die Amplitude des Taktsignals, welches von außen eingeprägt wird.

Die erfindungsgemäße Schaltungsanordnung ist vollständig in Dünnfilmtechnologie zu realisieren unter Verwendung der in der Dünnfilmtechnologie üblichen Materialien: polykristalline Halbleiter, zum Beispiel polykristallines Silizium, Cadmiumselenid, oder amorphe Halbleiter, zum Beispiel amorphes Silizium.

Die Schaltungsanordnung ist geeignet zur Ansteuerung von allen matrixförmig angeordneten Schaltelementen, insbesondere für die Bildpunkte eines Flüssigkristallbildschirms, oder auch für Schaltelemente, die in einer Kette angeordnet sind, zum Beispiel die Sensorelemente einer Bildsensorzeile und die Druckerelemente in einer Druckerkopfzeile.

Weitere Ausgestaltungen der Erfindung gehen aus den übrigen Ansprüchen hervor.

Im folgenden wird die Erfindung anhand eines Ausführungsbeispiels und der Figuren näher erläutert.
- Figur 1: zeigt den matrixförmigen Aufbau eines Flüssigkristallbildschirms.
- Figur 2: zeigt eine erfindungsgemäße Schaltungsanordnung zur Ansteuerung eines Schaltelementes.
- Figur 3: zeigt die in Figur 2 dargestellte Schaltungsanordnung in einer optimierten räumlichen Anordnung.
- Figur 4: zeigt eine Variante der in Figur 2 dargestellten Schaltungsanordnung.
- Figur 5: zeigt die in Figur 4 dargestellte Schaltungsanordnung in einer optimierten räumlichen Anordnung.
- Figur 6: zeigt den Impulsfahrplan mit den beiden Taktsignalen sowie den Spannungsverläufen in der Schaltung.
- Figur 7: zeigt eine Schaltungsanordnung mit zwei Schaltungsstufen zur Ansteuerung von zwei benachbarten Zeilen einer Matrix.

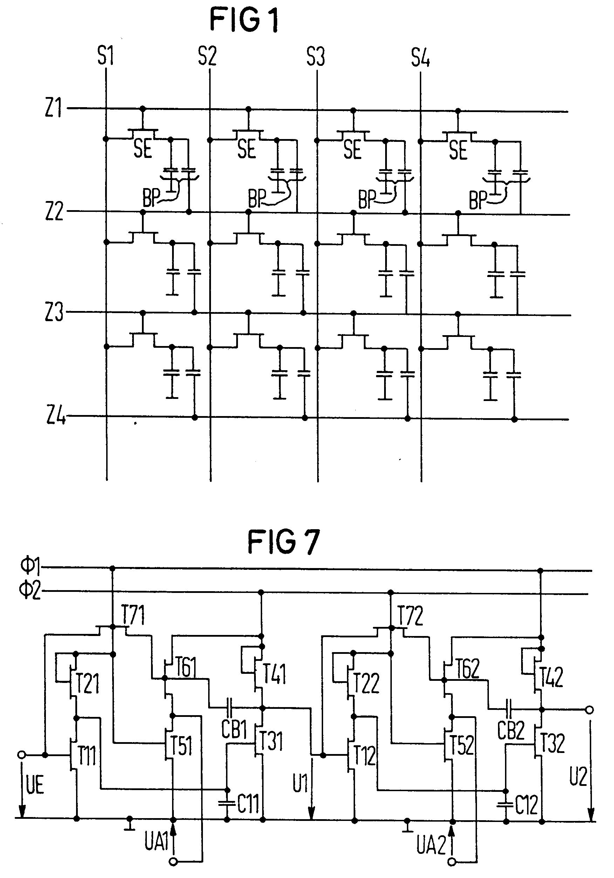

In Figur 1 sind vier Zeilenleitungen Z1, Z2, Z3, Z4 und vier Spaltenleitungen S1, S2, S3, S4 eines Flüssigkristallbildschirms dargestellt. In Form einer Matrix sind Schaltelemente SE und Bildpunktspeicher BP so angeordnet, daß jeweils ein Schaltelement SE und ein Bildpunktspeicher BP ein Paar bilden. Als Schaltelemente SE werden zum Beispiel Dünnfilmtransistoren verwendet. Die Steueranschlüsse von allen in einer Zeile angeordneten Schaltelementen SE sind mit der zugehörigen Zeilenleitung zum Beispiel S1 verbunden. Die ersten Anschlüsse aller Schaltelemente SE, die in einer Spalte, zum Beispiel der ersten Spalte, angeordnet sind, sind mit einer Spaltenleitung zum Beispiel S1 verbunden. Über die Zeilenleitungen Z1, Z2, Z3, Z4... erfolgt die Ansteuerung der Schaltelemente SE. Über die Spaltenleitungen S1, S2, S3, S4... erfolgt das Einschreiben der Bildinformation in die Bildpunktspeicher BP.

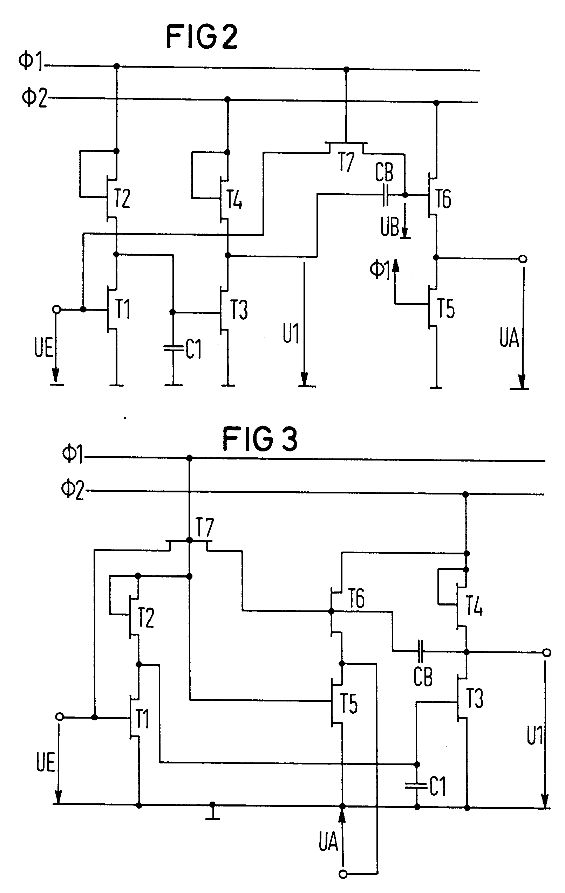

In Figur 2 ist eine erfindungsgemäße Schaltungsanordnung dargestellt. Es handelt sich um die Ansteuerschaltung für ein Schaltelement oder eine Zeile mit Schaltelementen, deren Steueranschlüsse mit dem Ausgang der Ansteuerschaltung verbunden sind.

Die Schaltungsanordnung enthält eine erste Inverterstufe. Die erste Inverterstufe ist zusammengesetzt aus einem ersten Transistor T1 und einem zweiten Transistor T2. Der Eingang der ersten Inverterstufe wird durch den Steueranschluß des ersten Transistors T1 gebildet. Der zweite Transistor T2 ist mit einem ersten Anschluß mit einer ersten Taktleitung φ1 verbunden. Mit der ersten Taktleitung φ1 ist ebenfalls der Steueranschluß des zweiten Transistors T2 verbunden. Ein zweiter Anschluß des zweiten Transistors T2 ist mit einem ersten Anschluß des ersten Transistors T1 verbunden. Ein zweiter Anschluß des ersten Transistors T1 ist mit dem Massepotential verbunden. Der Ausgang der ersten Inverterstufe liegt an dem ersten Anschluß des ersten Transistors T1.

Der Ausgang der ersten Inverterstufe ist über einen Ladekondensator C1 mit dem Massepotential verbunden.

Es ist eine zweite Inverterstufe vorgesehen, die aus einem dritten Transistor T3 und einem vierten Transistor T4 gebildet wird. Ein erster Anschluß des vierten Transistors T4 sowie der Steueranschluß sind mit einer zweiten Taktleitung φ2 verbunden. Ein zweiter Anschluß des vierten Transistors T4 ist mit einem ersten Anschluß des dritten Transistors T3 verbunden. Die Anschlüsse bilden den Ausgang der zweiten Inverterstufe. Der Steueranschluß des dritten Transistors T3 ist mit dem Ausgang der ersten Inverterstufe verbunden. Ein zweiter Anschluß des dritten Transistors T3 ist mit dem Massepotential verbunden.

Es ist eine Treiberstufe vorgesehen, die unter anderem aus einem Treibertransistor T6 und einem Entladetransistor T5 gebildet wird. Der Treibertransistor T6 ist mit einem ersten Anschluß mit der zweiten Taktleitung φ2 verbunden. Ein zweiter Anschluß des Treibertransistors T6 ist mit einem ersten Anschluß des Entladetransistors T5 verbunden, diese Anschlüsse bilden den Ausgang der Treiberstufe. Ein zweiter Anschluß des Entladetransistors T5 ist mit dem Massepotential verbunden. Der Steueranschluß des Entladetransistors T5 ist mit der ersten Taktleitung φ1 verbunden.

Desweiteren ist für die Treiberstufe ein Ladetransistor T7 vorgesehen. Ein erster Anschluß des Ladetransistors T7 ist mit dem Eingang der ersten Inverterstufe verbunden. Ein zweiter Anschluß des Ladetransistors T7 ist mit dem Steueranschluß des Treibertransistors T6 verbunden. Der Steueranschluß des Ladetransistors T7 ist mit der ersten Taktleitung φ1 verbunden.

Desweiteren ist für die Treiberschaltung ein Ladekondensator CB vorgesehen. Der Ausgang der zweiten Inverterstufe ist über den Ladekondensator CB mit dem Steueranschluß des Treibertransistors T6 verbunden.

In Figur 3 ist dieselbe Schaltung wie in Figur 2 dargestellt. Die einzelnen Elemente der Schaltung sind jedoch räumlich anders angeordnet. Die räumliche Anordnung wurde mit dem Ziel optimiert, möglichst wenig Leitungsüberkreuzungen zu bekommen. Die Optimierung der räumlichen Anordnung wurde dadurch realisiert, daß die Anschlüsse an die erste Taktleitung φ1 und die zweite Taktleitung φ2 jeweils zusammengefaßt wurden. Dazu wurden Transistoren, die Anschlüsse an dieselbe Taktleitung haben, benachbart angeordnet. So ist zum Beispiel der Ladetransistor T7 neben dem zweiten Transistor T2 angeordnet. Der erste Anschluß und der Steueranschluß des zweiten Transistors T2 sind mit dem Steueranschluß des Ladetransistors T7 verbunden und über diesen mit der ersten Taktleitung φ1.

Ferner sind der vierte Transistor T4 und der Treibertransistor T6 benachbart angeordnet. Der erste Anschluß des Treibertransistors T6 ist mit dem ersten Anschluß des vierten Transistors T4 und dessen Steueranschluß verbunden und über diese mit der zweiten Taktleitung φ2.

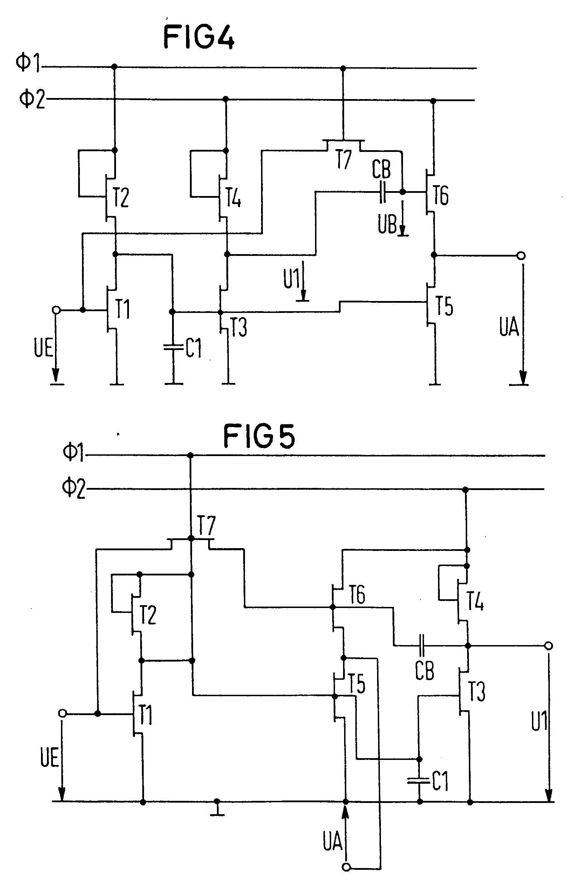

Im Gegensatz zur Anordnung aus Figur 2 wurde die Treiberstufe in Figur 4 zwischen dem ersten und dem zweiten Inverter angeordnet. Die Leitung mit dem Ausgangssignal für die Schaltelemente ist nach unten weggeführt. Der Eingang der folgenden Stufe kann direkt und ohne weitere Überkreuzungen mit dem Ausgang der Stufe verbunden werden.

In Figur 4 ist eine Variante der Schaltungsanordnung, die in Figur 2 dargestellt ist, gezeigt. Die Schaltungsanordnungen sind fast identisch aufgebaut. Sie unterscheiden sich lediglich im Anschluß des Steueranschlusses für den Entladetransistor T5. In der hier dargestellten Variante ist der Steueranschluß des Entladetransistors T5 mit dem Ausgang der ersten Inverterstufe verbunden.

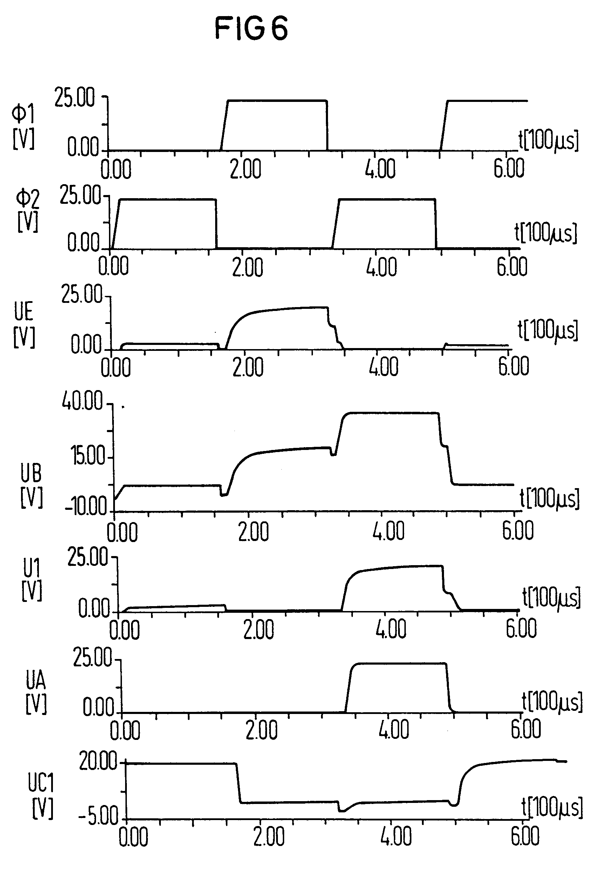

In Figur 5 ist dieselbe Schaltung wie in Figur 4 dargestellt, jedoch in einer optimierten räumlichen Anordnung. Die Optimierung erfolgte nach denselben Gesichtspunkten wie für Figur 3 erläutert. In dieser Schaltungsanordnung treten lediglich drei Leitungsüberkreuzungen auf, im Gegensatz zu vier Überkreuzungen bei der Anordnung aus Figur 3.

Anhand von Figur 6 wird im folgenden das Prinzip der Schaltung erläutert.

Nimmt das Taktsignal φ1 an der ersten Inverterstufe ein hohes Potential an und wird der Eingang gleichzeitig mit einem Impuls UE beaufschlagt, so kann sich die Kapazität CB über den Ladetransistor T7 aufladen (vergleiche Figur 2, Figur 4). Der Ladekondensator C1 wird sich während der Pulsdauer des Taktes φ1 entladen. Während das Taktsignal φ2 an der zweiten Inverterstufe eine hohe Spannung annimmt, wird die Ausgangsspannung U1 am Ausgang der ersten Inverterstufe ansteigen. Am Steueranschluß des Treibertransistors T6 addiert sich die Ladespannung des Speicherkondensators CB zur Ausgangsspannung U1. Das am Steueranschluß das Treibertransistors T6 anliegende Potential ist wesentlich größer als die Amplitude des zweiten Taktsignals φ2, die an dem ersten Anschluß des Treibertransistors T6 anliegt. Dadurch ist gewährleistet, daß die volle Taktamplitude des zweiten Taktsignals φ2 am Ausgang der Treiberstufe als Ausgangssignal UA zur Verfügung steht. Dieses Signal wird zum Schalten des Schaltelementes verwendet. Dem Impulsfahrplan der Taktsignale und den Spannungsverläufen in Figur 6 ist zu entnehmen, daß eine Taktamplitude des zweiten Taktsignals φ2 von knapp 25 Volt und ein Eingangsimpuls UE von ebenfalls knapp 25 Volt einem Potential an der Steuerelektrode des ersten Treibertransistors T6 von fast 40 Volt entspricht. Da das Eingangssignal UE und die Taktsignale φ1 und φ2 von außen eingeprägt werden, kann die Amplitude dieser Signale so gewählt werden, daß ein sicheres Durchschalten der Schaltelemente gewährleistet ist.

Die Entladung des Ausgangs UA erfolgt über den Treibertransistor T6, kurz nachdem das zweite Taktsignal φ2 wieder auf den niedrigen Pegel gefallen ist. Erst wenn die Ausgangskapazität fast vollständig entladen ist, wird der Ausgang über den Entladetransistor T5 niederohmig mit dem Massepotential verbunden. Das erfolgt dadurch, daß entweder der Entladetransistor T5 mit dem (nun wieder ansteigenden) ersten Taktsignal φ1 verbunden wird (siehe Figur 2) oder daß der Steueranschluß des Entladetransistors T5 mit dem Ausgang der ersten Inverterstufe verbunden wird (siehe Figur 4).

Der Ausgang der ersten Inverterstufe liegt auf hohem Potential, solange am Eingang der ersten Inverterstufe kein Eingangssignal anliegt. In einer N-stufigen Schaltungsanordnung zum Ansteuern von N Zeilen liegt das Eingangssignal UE für die erste Zeile nur während 1/N-tel der Bildaufbauzeit auf hohem Potential. In der übrigen Zeit liegt es auf tiefem Potential. Deshalb liegt gemäß Figur 6 bis auf eine Taktperiode während der gesamten Bildaufbauzeit am Ausgang des ersten Inverters eine hohe Spannung an. Daher hat die Variante der Schaltungsanordnung, die in Figur 4 dargestellt ist und bei der der Steueranschluß des Entladetransistors T5 mit dem Ausgang der ersten Inverterstufe verbunden ist, den Vorteil, daß der Ausgang der Treiberstufe meistens niederohmig mit dem Massepotential verbunden ist. Damit fließen eventuell eingekoppelte Störsignale sofort ab.

In Figur 7 ist eine zweistufige Schaltungsanordnung zur Ansteuerung von zwei Zeilen mit Schaltelementen dargestellt. Beide Schaltungsstufen sind analog aufgebaut und angeordnet wie die anhand von Figur 2 und Figur 3 beschriebene Schaltungsanordnung. Das Ausgangssignal U1 der zweiten Inverterstufe in der ersten Schaltungsstufe bildet dabei das Eingangssignal für die erste Inverterstufe der zweiten Schaltungsstufe. Der Ausgang UA1 der Treiberstufe der ersten Schaltungsstufe wird mit der ersten Zeile verbunden. Der Ausgang UA2 der Treiberstufe der zweiten Schaltungsstufe wird mit der zweiten Zeile verbunden. Die erste Inverterstufe der zweiten Schaltungsstufe wird mit dem zweiten Taktsignal φ2 verbunden. Die zweite Inverterstufe der zweiten Schaltungsstufe wird mit dem Taktsignal φ1 verbunden. Durch diese Anschlußweise der Taktsignale ist sichergestellt, daß der Ladetransistor T72 den Speicherkondensator CB2 auflädt, wenn das Taktsignal φ2 hohes Potential besitzt und der Ausgang der zweiten Inverterstufe der ersten Schaltungsstufe den Spannungsimpuls liefert. Einen Halbtakt später wird der Treibertransistor T62 mit dem Taktsignal φ1 leitend und die Spannung am Ausgang der zweiten Schaltungsstufe UA2 wird bis auf die Taktamplitude ansteigen. Davor hat sich bereits die Lastkapazität am Ausgang der ersten Schaltungsstufe entladen und ist nun niederohmig über den Entladetransistor T51 mit dem Masseanschluß verbunden.

Analog der in Figur 7 gezeigten zweistufigen Schaltungsanordnung läßt sich eine N-stufige Schaltungsanordnung zur Ansteuerung von Schaltelementen aufbauen, die in N Zeilen angeordnet sind. Die Taktanschlüsse zweier aufeinanderfolgender Zeilentreiberstufen sind jeweils vertauscht, so daß zum Beispiel am ersten Inverter der nächsten Stufe das Taktsignal φ2 anliegt, wenn am ersten Inverter der vorangegangenen Stufe das Taktsignal φ1 anliegt.

Die Schaltung läßt sich gut in Dünnfilmtechnologie realisieren, so daß eine Integration auf einem Substrat von der Ansteuerschaltung und zum Beispiel einem Flüssigkristallbildschirm möglich ist.

Die Ansteuerschaltung kann auch bei der Ansteuerung von Bildsensorzeilen oder Druckerkopfzeilen eingesetzt werden.

## Patentansprüche

1. Schaltungsanordnung zur Ansteuerung eines Schaltelementes mit
- einer Schieberegisterstufe (T1, T2, T3, T4, C1), die einen Eingangsimpuls (UE) mit Hilfe von zwei Taktsignalen (Φ1, Φ2) zeitverzögert an den Ausgang der Schieberegisterstufe überträgt, und
- einer Treiberschaltung, die mindestens einen Treibertransistor (76) und einen Speicherkondensator (CB) enthält, der während des Anliegens des Eingangsimpulses (UE) an der Schieberegisterstufe vorgeladen wird und dafür sorgt, daß der Treibertransistor (T6) durch eine hohe Steuerspannung große Lade- und Entladeströme liefert, wobei
- der Steueranschluß des Treibertransistors (T6) über einen Ladetransistor (T7) mit dem Eingang der Schieberegisterstufe (T1, T2, T3, T4, C1) verbunden ist,
- der Steueranschluß des Ladetransistors (T7) mit dem ersten Taktsignal (Φ1) verbunden ist, und
- der Ausgang der Schieberegisterstufe (T1, T2, T3, T4, C1) über den Speicherkondensator (CB) mit dem Steueranschluß des Treibertransistors (T6) verbunden ist.

2. Schaltungsanordnung nach Anspruch 1, bei der
in der Treiberschaltung ein Entladetransistor (T5) vorgesehen ist, dessen erster Anschluß mit dem Ausgang des Treibertransistors (T6) und dessen zweiter Anschluß mit dem Massepotential verbunde ist und wobei
der Entladetransistor (T5) so gesteuert wird, daß er sperrt, wenn der Treibertransistor (T6) leitet.

3. Schaltungsanordnung nach Anspruch 3, bei der der Steueranschluß des Entladetransistors (T5) mit dem ersten Taktsignal (Φ1) verbunden ist.

4. Schaltungsanordnung nach Anspruch 2 oder 3, bei der
die Schieberegisterstufe aus zwei getakteten Inverterstufen (T1, T2, T3, Tf) besteht, deren Versorgungsleitungen jeweils mit einem der Taktsignale (Φ1, Φ2) verbunden sind, und einem Ladekondensator (C1),
der Eingang der ersten Inverterstufe (T1, T2) den Eingang der Schieberegisterstufe bildet,
der Ausgang der ersten Inverterstufe (T1, T2) mit dem Eingang der zweiten Inverterstufe (T3, T4) und über den Ladekondensator (C1) mit dem Massepotential verbunden ist, und
der Ausgang der zweiten Inverterstufe (T3, T4) den Ausgang des Schieberegisters bildet.

5. Schaltungsanordnung nach Anspruch 4, bei der der Steueranschluß des Entladetransistors (T5) mit dem Ausgang der ersten Inverterstufe (T1, T2) verbunden ist.

6. Schaltungsanordnung nach einem der Ansprüche 1 bis 5, bei der das zweite Taktsignal (Φ2) über den Treibertransistor (T6) mit dem Ausgang der Treiberschaltung verbunden ist, so daß das zweite Taktsignal (Φ2) zum Ansteuern des Schaltelementes verwendet wird.

7. Schaltungsanordnung nach einem der vorstehenden Ansprüche zur Ansteuerung von kettenförmig oder matrixförmig angeordneten Schaltelementen mit folgenden Merkmalen:
a) jeweils ein Schaltelement einer Kette bzw. alle Schaltelemente einer Zeile einer Matrix von Schaltelementen werden von einer Schaltungsstufe angesteuert, deren Ausgang mit dem Steueranschluß des Schaltelementes der Kette oder gleichzeitig mit allen Steueranschlüssen der Schaltelemente einer Zeile einer Matrix von Schaltelementen verbunden ist,
b) jede Schaltungsstufe besteht aus einer Schieberegisterstufe (T1, T2, T3, T4, C1) und einer Treiberschaltung (T5, T6, T7, CB),
c) die Schieberegisterstufe besteht aus zwei getakteten Inverterstufen (T1, T2, T3, T4), deren Versorgungsleitungen mit jeweils einem Taktsignal verbunden sind, und einem Ladekondensator (C1),
d) der Ausgang der ersten Inverterstufe (T1, T2) ist mit dem Eingang der zweiten Inverterstufe (T3, T4) und über den Ladekondensator (C1) mit dem Massepotential verbunden,
e) der Ausgang der zweiten Inverterstufe (T3, T4) in der Schaltungsstufe einer Zeile ist mit dem Eingang der ersten Inverterstufe (T1, T2) der Schaltungsstufe der nächsten Zeile verbunden,
f) die Treiberschaltung enthält einen Treibertransistor (T6), dessen Steueranschluß über einen Ladetransistor (T7) mit dem Eingang der ersten Inverterstufe (T1, T2) und über einen Speicherkondensator (CB) mit dem Ausgang der zweiten Inverterstufe (T3, T4) verbunden ist,
g) der Treibertransistor (T6) ist mit einem ersten Anschluß mit dem Taktsignal der zweiten Inverterstufe (T3, T4) verbunden,
h) ein zweiter Anschluß des Treibertransistors (T6) bildet den Ausgang der Treiberschaltung,
i) der Ausgang der Treiberschaltung ist über einen Entladetransistor (T5) mit dem Massepotential verbunden,
j) der Steueranschluß des Entladetransistors (T5) und der Steueranschluß des Ladetransistors (T7) sind mit dem Taktsignal der ersten Inverterstufe (T1, T2) verbunden,
k) das Taktsignal der ersten Inverterstufe einer Schaltungsstufe ist in der nächsten Schaltungsstufe das Taktsignal der zweiten Inverterstufe,
l) das Taktsignal der zweiten Inverterstufe einer Schaltungsstufe ist in der nächsten Schaltungsstufe das Taktsignal der ersten Inverterstufe.

8. Schaltungsanordnung nach Anspruch 7, bei der der Steueranschluß des Entladetransistors (T5) mit dem Ausgang der ersten Inverterstufe (T1, T2) verbunden ist.

9. Schaltungsanordnung nach einem der Ansprüche 1 bis 9, die in Dünnfilmtechnik unter Verwendung eines der Materialien: polykristalline Halbleiter, zum Beispiel Cadmiumselenid und Polysilizium, oder amorphe Halbleiter, zum Beispiel amorphes Silizium, realisiert ist.

10. Schaltungsanordnung nach einem der Ansprüche 1 bis 9, bei der die Schaltelemente die Bildpunkte eines Flüssigkristallbildschirms ansteuern.

11. Schaltungsanordnung nach Anspruch 10, die auf einem gemeinsamen Substrat mit dem Flüssigkristallbildschirm realisiert ist.

12. Schaltungsanordnung nach einem der Ansprüche 1 bis 9, bei der die Schaltelemente Sensorelemente einer Bildsensorzeile ansteuern.

13. Schaltungsanordnung nach Anspruch 12, die auf einem gemeinsamen Substrat mit der Bildsensorzeile realisiert ist.

14. Schaltungsanordnung nach einem der Ansprüche 1 bis 9, bei der die Schaltelemente Druckerelemente in einer Druckerkopfzeile ansteuern.

15. Schaltungsanordnung nach Anspruch 14, die auf einem gemeinsamen Substrat mit der Druckerkopfzeile realisiert ist.

## Claims

1. A circuit for triggering a switching element, comprising
- a shift register stage (T1, T2, T3, T4, C1) which transmits an input pulse (UE) with a time delay by means of two clock signals (φ1, φ2) to the output of the shift register stage, and
- a driver circuit comprising at least one driver transistor (76) and a storage capacitor (CB) which, during the application of the input pulse (UE) to the shift register stage, is pre-charged and ensures that the driver transistor (T6) delivers high charging and discharge currents by means of a high control voltage,
- the control junction of the driver transistor (T6) being connected via a charging transistor (T7) to the input of the shift register stage (T1, T2, T3, T4, C1),
- the control junction of the charging transistor (T7) being connected to the first clock signal (φ1), and
- the output of the shift register stage (T1, T2, T3, T4, C1) being connected via the storage capacitor (CB) to the control junction of the driver transistor (T6).

2. A circuit according to claim 1, wherein
the driver circuit contains a discharge transistor (T5), the first junction of which is connected to the output of the driver transistor (T6) and the second junction of which is connected to earth potential, and wherein
the discharge transistor (T5) is so controlled as to cut off when the driver transistor (T6) conducts.

3. A circuit according to claim 3, wherein the control junction of the discharge transistor (T5) is connected to the first clock signal (φ1).

4. A circuit according to claim 2 or 3, wherein
the shift register stage consists of two clocked inverter stages (T1, T2, T3, Tf), the supply lines of which are each connected to one of the clock signals (φ1, φ2), and a charging capacitor (C1),
the input of the first inverter stage (T1, T2) forms the input of the shift register stage,
the output of the first inverter stage (T1, T2) is connected to the input of the second inverter stage (T3, T4) and, via the charging capacitor (C1), to earth potential, and
the output of the second inverter stage (T3, T4) forms the output of the shift register.

5. A circuit according to claim 4, wherein the control junction of the discharge transistor (T5) is connected to the output of the first inverter stage (T1, T2).

6. A circuit according to any one of claims 1 to 5, wherein the second clock signal (φ2) is connected via the driver transistor (T6) to the output of the driver circuit so that the second clock signal (φ2) is used to trigger the switching element.

7. A circuit according to any one of the preceding claims for triggering switching elements arranged in the form of a chain or matrix with the following features:
a) each switching element of a chain or all the switching elements of a line of a matrix of switching elements are triggered by a circuit stage whose output is connected to the control junction of the switching element of the chain or simultaneously to all the control junctions of the switching elements of a line of a matrix of switching elements,
b) each circuit stage consists of a shift register stage (T1, T2, T3, T4, C1) and a driver circuit (T5, T6, T7, CB),
c) the shift register stage consists of two clocked inverter stages (T1, T2, T3, T4), the supply lines of which are each connected to a clock signal, and a charging capacitor (C1).
d) the output of the first inverter stage (T1, T2) is connected to the input of the second inverter stage (T3, T4) and, via the charging capacitor (C1), to earth potential,
e) the output of the second inverter stage (T3, T4) in the circuit stage of a line is connected to the input of the first inverter stage (T1, T2) of the circuit stage of the next line,
f) the driver circuit comprises a driver transistor (T6), the control junction of which is connected via a charging transistor (T7) to the input of the first inverter stage (T1, T2) and via a storage capacitor (CB) to the output of the second inverter stage (T3, T4),
g) the driver transistor (T6) is connected by a first junction to the clock signal of the second inverter stage (T3, T4),
h) a second junction of the driver transistor (T6) forms the driver circuit output,
i) the driver circuit output is connected to earth potential via a discharge transistor (T5),
j) the control junction of the discharge transistor (T5) and the control junction of the charging transistor (T7) are connected to the clock signal of the first inverter stage (T1, T2),
k) the clock signal of the first inverter stage of a circuit stage is, in the next circuit stage, the clock signal of the second inverter stage,
l) the clock signal of the second inverter stage of a circuit stage is, in the next circuit stage, the clock signal of the first inverter stage.

8. A circuit according to claim 7, wherein the control junction of the discharge transistor (T5) is connected to the output of the first inverter stage (T1, T2).

9. A circuit according to any one of claims 1 to 9, embodied in thin-film technique using one of the following materials: polycrystalline semiconductors, e.g. cadmium selenide and polysilicon, or amorphous semiconductors, e.g. amorphous silicon.

10. A circuit according to any one of claims 1 to 9, wherein the switching elements trigger the image dots of a liquid crystal display.

11. A circuit according to claim 10, embodied on a common substrate with the liquid crystal display.

12. A circuit according to any one of claims 1 to 9, wherein the switching elements trigger sensor elements of an image sensor line.

13. A circuit according to claim 12, embodied on a common substrate with the image sensor line.

14. A circuit according to any one of claims 1 to 9, wherein the switching elements trigger printer elements in a printer head line.

15. A circuit according to claim 14, embodied on a common substrate with the printer head line.

## Revendications

1. Circuit de commande d'un élément de commutation comportant
- un étage de registre à décalage (T1, T2, T3, T4, C1), qui transmet une impulsion d'entrée (UE) à l'aide de deux signaux d'horloge (φ1, φ2) de façon différée à la sortie de l'étage de registre à décalage, et
- un circuit d'excitation, qui comprend au moins un transistor d'excitation (76) et un condensateur de mémoire (CB), qui est préchargé durant l'application de l'impulsion d'entrée (UE) à l'étage de registre à décalage et assure que le transistor d'excitation (T6) délivre grâce à une tension de commande élevée des courants intenses de charge et de décharge,
- la borne de commande du transistor d'excitation (T6) est reliée par l'intermédiaire d'un transistor de charge (T7) à l'entrée de l'étage de registre à décalage (T1, T2, T3, T4, C1),
- la borne de commande du transistor de charge (T7) est reliée au premier signal d'horloge (φ1), et
- la sortie de l'étage de registre à décalage (T1, T2, T3, T4, C1) est reliée par l'intermédiaire du condensateur de mémoire (CB) à la borne de commande du transistor d'excitation (T6).

2. Circuit selon la revendication 1, dans lequel dans le circuit d'excitation est prévu un transistor de décharge (T5), dont la première borne est reliée à la sortie du transistor d'excitation (T6) et dont la seconde borne est reliée au potentiel de la masse, et
le transistor de décharge (T5) est commandé de sorte qu'il soit bloqué lorsque le transistor d'excitation (T6) conduit.

3. Circuit selon la revendication 2, dans lequel la borne de commande du transistor de décharge (T5) est reliée au premier signal d'horloge (φ1).

4. Circuit selon la revendication 2 ou 3, dans lequel l'étage de registre à décalage se compose de deux étages inverseurs (T1, T2, T3, Tf) commandés par horloge, dont les lignes d'alimentation sont réunies respectivement à l'un des signaux d'horloge (φ1, φ2), et d'un condensateur de charge (C1),
l'entrée du premier étage inverseur (T1, T2) constitue l'entrée de l'étage de registre à décalage,
la sortie du premier étage inverseur (T1, T2) est reliée à l'entrée du second étage inverseur (T3, T4) et par l'intermédiaire du condensateur de charge (C1) au potentiel de la masse,
la sortie du second étage inverseur (T3, T4) constitue la sortie du registre à décalage.

5. Circuit selon la revendication 4, dans lequel la borne de commande du transistor de décharge (T5) est reliée à la sortie du premier étage inverseur (T1, T2).

6. Circuit selon l'une des revendications 1 à 5, dans lequel le second signal d'horloge (φ2) est relié par l'intermédiaire du transistor d'excitation (T6) à la sortie du circuit d'excitation, de sorte que le second signal d'horloge (φ2) est utilisé pour la commande de l'élément de commutation.

7. Circuit selon l'une des revendications précédentes en vue de la commande d'éléments de commutation disposés sous forme de chaîne ou de matrice, caractérisé en ce que :
a) chaque élément de commutation d'une chaîne ou tous les éléments de commutation d'une ligne d'une matrice d'éléments de commutation sont commandés par un étage de circuit, dont la sortie est reliée à la borne de commande de l'élément de commutation de la chaîne ou simultanément à toutes les bornes de commande des éléments de commutation d'une ligne d'une matrice d'éléments de commutation,
b) chaque étage de circuit se compose d'un étage de registre à décalage (T1, T2, T3, T4, C1) et d'un circuit d'excitation (T5, T6, T7, CB),
c) l'étage de registre à décalage se compose de deux étages inverseurs (T1, T2, T3, T4) commandés par horloge, dont les lignes d'alimentation sont reliées respectivement à un signal d'horloge, et d'un condensateur de charge (C1),
d) la sortie du premier étage inverseur (T1, T2) est reliée à l'entrée du second étage inverseur (T3, T4) et par l'intermédiaire du condensateur de charge (C1) au potentiel de la masse,
e) la sortie du second étage inverseur (T3, T4) dans l'étage de circuit d'une ligne est reliée à l'entrée du premier étage inverseur (T1, T2) de l'étage de circuit de la ligne suivante,
f) le circuit d'excitation comporte un transistor d'excitation (T6) dont l'entrée de commande est reliée par l'intermédiaire d'un transistor de charge (T7) à l'entrée du premier étage inverseur (T1, T2) et par l'intermédiaire d'un condensateur de mémoire (CB) à la sortie du second étage inverseur (T3, T4),
g) le transistor d'excitation (T6) est relié par une première borne au signal d'horloge du second étage inverseur (T3, T4),
h) une seconde borne du transistor d'excitation (T6) constitue la sortie du circuit d'excitation,
i) la sortie du circuit d'excitation est reliée par l'intermédiaire d'un transistor de décharge (T5) au potentiel de la masse,
j) la borne de commande du transistor de décharge (T5) et la borne de commande du transistor de charge (T7) sont reliées au signal d'horloge du premier étage inverseur (T1, T2),
k) le signal d'horloge du premier étage inverseur d'un étage de circuit est dans l'étage de circuit suivant le signal d'horloge du second étage inverseur,
l) le signal d'horloge du second étage inverseur d'un étage de circuit est dans l'étage de circuit suivant le signal d'horloge du premier étage inverseur.

8. Circuit selon la revendication 7, dans lequel la borne de commande du transistor de décharge (T5) est reliée à la sortie du premier étage inverseur (T1, T2).

9. Circuit selon l'une des revendications 1 à 8, qui est réalisé par technologie à film mince avec utilisation d'un des matériaux : semiconducteurs polycristallins, par exemple séléniure de cadmium et silicium polycristallin, ou semiconducteurs amorphes, par exemple du silicium amorphe.

10. Circuit selon l'une des revendications 1 à 9, dans lequel les éléments de commutation commandent les points d'image d'un écran à cristaux liquides.

11. Circuit selon la revendication 10, qui est réalisé sur un substrat commun avec l'écran à cristaux liquides.

12. Circuit selon l'une des revendications 1 à 9, dans lequel les éléments de commutation commandent des éléments de capteur d'une ligne de capteur d'image.

13. Circuit selon la revendication 12, qui est réalisé sur un substrat commun avec la ligne de capteur d'image.

14. Circuit selon l'une des revendications 1 à 9, dans lequel les éléments de commutation commandent des éléments d'impression dans une ligne de tête d'impression.

15. Circuit selon la revendication 14, qui est réalisé sur un substrat commun avec la ligne de tête d'impression.
